Europäisches Patentamt

European Patent Office

Office européen des brevets

(11) Veröffentlichungsnummer : **0 371 972 B1**

(19)

(12) **EUROPÄISCHE PATENTSCHRIFT**

(45) Veröffentlichungstag der Patentschrift :
26.08.92 Patentblatt 92/35

(21) Anmeldenummer : 88904915.1

(22) Anmeldetag : 10.06.88

(86) Internationale Anmeldenummer :
**PCT/DE88/00344**

(87) Internationale Veröffentlichungsnummer :
**WO 89/00498 26.01.89 Gazette 89/03**

(51) Int. Cl.⁵ : **B32B 17/10, C03C 27/12**

(54) **VERFAHREN ZUM VERKLEBEN ZWEIER FLACHER TEILE MIT PHOTORESISTFOLIE.**

(30) Priorität : **10.07.87 DE 3722923**

(43) Veröffentlichungstag der Anmeldung :
**13.06.90 Patentblatt 90/24**

(45) Bekanntmachung des Hinweises auf die
Patenterteilung :
**26.08.92 Patentblatt 92/35**

(84) Benannte Vertragsstaaten :
**CH DE FR GB IT LI NL SE**

(56) Entgegenhaltungen :
**DE-A- 2 245 288**
**DE-A- 3 507 112**

(56) Entgegenhaltungen :
**DE-A- 3 508 764**
**FR-A- 2 297 872**
**FR-A- 2 344 866**
**US-A- 4 039 720**
**IBM Technical Disclosure Bulletin, Vol. 13,**
**No.5, October 1970 (New York, US), A.E. Peter**
**"Photosensitive resists", p. 1146**

(73) Patentinhaber : **SIEMENS**
**AKTIENGESELLSCHAFT**
**Wittelsbacherplatz 2**
**W-8000 München 2 (DE)**

(72) Erfinder : **TRAUSCH, Günter, Elmar**
**Feldafinger Str. 39**
**W-8000 München 71 (DE)**

## Beschreibung

Die Erfindung bezieht sich auf die Verbindung von zwei flachen Teilen, zum Beispiel aus Glas, von denen das eine in der Verbindungsfläche Vertiefungen mit einem oder mehreren Durchbrüchen aufweist, zum Beispiel Tintenwannen beim Bubble Jet Printer, und Verfahren zur Realisierung dieser Verbindung.

Als Verfahren zur Herstellung eines Tintenstrahlkopfs wurde beispielsweise ein Verfahren vorgeschlagen, bei dem auf einer Platte aus einem Glasmaterial oder einem Metall sehr kleine Nuten durch Schneiden oder Ätzen eingeformt werden, wonach die mit derartigen Nuten ausgestattete Platte mit einer anderen geeigneten Platte zur Bildung der Tintenströmungsführungen verbunden wird. In der DE-OS 3 222 680, in der auf ein derartiges Verfahren hingewiesen ist, wird aber über die Klebetechnik zwischen den Platten nichts ausgesagt.

Aus IBM Technical Disclosure Bulletin, Band 13, Nr. 5, Oktober 1970, Seite 1146 ist es bekannt, Photoresistfolien für die zeitweilige, partielle Verbindung von zwei Teilen einzusetzen. Dabei wird insbesondere auf die Verbindung von elektrisch leitenden Oberflächen mit einer Maske für die nachfolgende galvanische Metallabscheidung hingewiesen.

Aus der US-A-4 039 720 ist ein Verfahren zur Herstellung von Sicherheitsglas bekannt, bei welchem ein transparenter thermoplastischer Polyurethanfilm auf eine Schicht aus starrem Glas auflaminiert wird. Der thermoplastische Polyurethanfilm enthält einen Photoinitiator, der nach dem Laminieren durch Bestrahlung eine Vernetzung des Polyurethanfilms im Oberflächenbereich bewirkt und dadurch die optischen und mechanischen Eigenschaften des Laminats verbessert.

Aus der FR-A-2 344 866 ist eine optische Aufzeichnungsanordnung bekannt, bei welcher nacheinander eine optische Linsen enthaltende Schicht, eine Photomaske und eine photosensible Schicht angeordnet sind, wobei mindestens eine dieser Schichten auf einen Träger aufgebracht ist und wobei die Schichtenfolge mindestens eine Schicht aus einem transparenten Kunststoff enthält.

Aus der DE-A-3 507 112 ist ein Tintenstrahlaufzeichnungskopf bekannt, der eine auf einem Glassubstrat befindliche ausgehärtete Photoresistfolie zur Ausbildung von Tintenbahnen und Tintenspeichern und eine darüber angeordnete, beispielsweise aus Glas bestehende Abdeckung aufweist. Die Ausbildung von Tintenbahnen und Tintenspeichern in der Photoresistfolie wird auf photolithographischem Wege mit Hilfe einer Photomaske vorgenommen, die vor der Belichtung auf die Photoresistfolie aufgebracht und nach der Belichtung wieder entfernt wird.

Der Erfindung liegt die Aufgabe zugrunde, eine Lösung für die eingangs genannte Verbindung zu konzipieren. Voraussetzung ist, daß diese Verbindung über große Zeiträume hochfrequente Druckimpulse aushält, tintenbeständig ist und die Tintenkanalquerschnitte beim Verbindungsvorgang nicht verändert werden.

Diese Aufgabe wird gemäß dem Kennzeichen des Anspruchs 1 gelöst. Vorteilhafte Ausführungsformen und Weiterbildungen der Erfindung sind in den Unteransprüchen enthalten. Als Klebeschicht sind Photoresistfolien (Trockenresists) nur dann geeignet, wenn damit die Funktionen der Tintenzuführöffnung und der Tintenwanne nicht beeinträchtigt werden. Ein Ausschneiden der Folie im Bereich der Tintenwanne ist zu ungenau (Schnitt- und Positioniergerauigkeit).

Mit der Lösung nach der Erfindung werden die der Aufgabe zugrundeliegenden Bedingungen erfüllt. Die Folien sind handelsüblich und in verschiedenen Dicken verfügbar.

Für die Realisierung des prinzipiellen erfinderischen Gedankens, die Resistfolie mit der sie abdeckenden Schutzfolie in bekannter Weise ganzflächig auf die Glasplatte zu kaschieren, wobei die Tintenwanne überspannt wird, werden zwei voneinander unabhänge Problemlösungen geltend gemacht:

Vorschlag 1:

Die Resistfolie wird im Wannenbereich tiefgezogen, so daß die Wannenwände mit Resist ausgekleidet sind. Am Tintenzufuhrloch wird der Resist geöffnet.

Vorschlag 2:

Die Resistfolie wird im Bereich der Tintenwanne entfernt und ist dann nur noch an der zu klebenden Oberfläche vorhanden.

Zu Vorschlag 1:

Photoresistfolien sind thermoplastisch und daher zum Tiefziehen geeignet. Die Hersteller bieten sogenannte Vakuumlaminatoren an, in denen die Resistfolie mit der Schutzfolie zusammen über Oberflächenreliefs (wie Leiterbahnen auf Leiterplatten) ohne Lufteinschluß kaschiert wird. Das funktioniert aber nur bis zu Re-

2

liefhöhen, die der Foliendicke entsprechen (zur Zeit 25 bis 100 µm). Die Tintenwanne ist 500 µm tief.

Nach Vorschlag 1 wird die Schutzfolie vor dem Tiefziehen abgezogen. Das ist möglich, weil im Gegensatz zur üblichen Anwendung keine Belichtung mit Maske erfolgt, bei der die Maske an der nunmehr klebrigen Oberfläche haften würde. Bei manchen Folientypen haftet die Schutzfolie so fest auf dem Resist, daß sie beim Abziehen über der Wanne Resistteile mit herausreißt. Hier hilft eine Belichtung mit sehr geringer Dosis dieser Bereiche durch die Schutzfolie mit Hilfe einer Maske; die Tiefziehfähigkeit leidet kaum.

Die Erfindung wird anhand eines Ausführungsbeispiels in den Figuren erläutert. Es zeigen:

Figur 1 einen Schnitt durch ein Substrat mit einer Tintenwanne,

Figur 2 die Draufsicht auf die Wanne nach Figur 1,

Figur 3 einen Schnitt durch eine Unterdruckkammer,

Figur 4 das Oberflächenrelief einer Kanalplatte mit aufgelegtem Glassubstrat vor der Kleberstrukturierung,

Figur 5 den Schnitt VV in Figur 4 und

Figur 6 eine Einzelheit bei VI in der Figur 5.

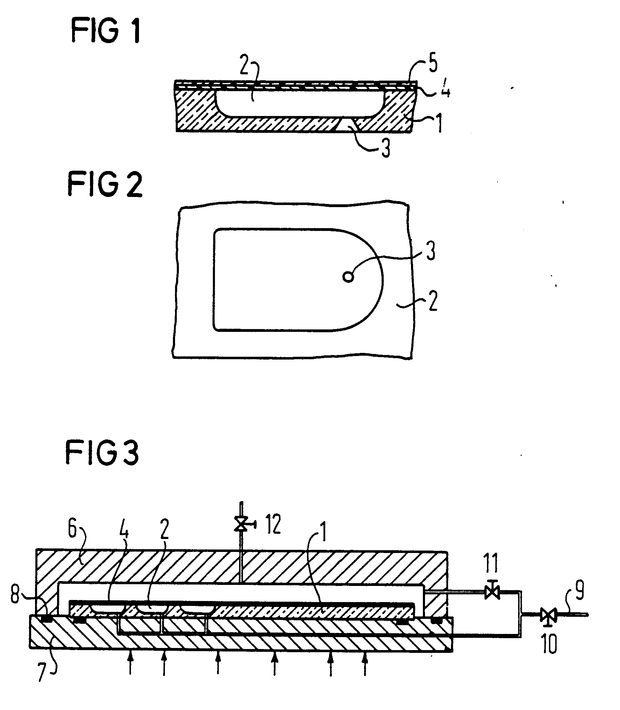

In den Figuren ist mit 1 ein Substrat, zum Beispiel aus Glas, bezeichnet, das muldenförmige Tintenwannen 2 aufweist. Im Boden jeder Wanne ist ein Tintenzuführloch 3 vorgesehen. Über der Wanne ist eine Resistfolie 4 mit einer Schutzfolie 5 angedeutet. Eine Unterdruckkammer nach der Figur 3 besteht aus einem Oberteil 6 und einem Unterteil 7, die mit Hilfe von Dichtungen 8 luftdicht verbunden werden können. In dieser Kammer liegt das Substrat 1. Eine Vakuumleitung 9 ermöglicht die Evakuierung der Kammer, und zwar mit getrennten Drucken unterhalb und oberhalb des Substrats mit Hilfe von Ventilen 10 bis 12. Das Unterteil 7 ist beheizbar. Der Wärmefluß ist durch die Pfeile angedeutet.

Das Fließverhalten der Resistfolie beim Tiefziehen kann über die Parameter Temperatur und Druckdifferenz gesteuert werden. Ein Tiefziehen mit Stempeln erscheint wenig geeignet (Resistausrisse, Lufteinschlüsse, Positionierproblem). Nach der Erfindung erfolgt ein kontaktloser Tiefziehprozeß mit Druckunterschieden beiderseits der Folie, zum Beispiel in dem Kammerunterteil 7 der Figur 3 durch Anlegen eines Unterdruckes im Wannenraum (Absaugen der Luft durch das Tintenloch), bei erhöhter Temperatur. Je nach Wannenform und Lage des Tintenloches können dabei Lufteinschlüsse entstehen. Dann wird, wie in der Figur 3 dargestellt, verfahren: Das Substrat 1, zum Beispiel in Form einer Glasplatte, liegt in einer Kammer, die aus den trennbaren Ober- und Unterteilen 6/7 besteht. Bei geöffneten Ventilen 10 und 11 und geschlossenem Ventil 12 wird zunächst die Kammer evakuiert, dann das Ventil 11 geschlossen und Ventil 12 geöffnet. Der Überdruck im Kammeroberteil drückt die temperierte Resistfolie an die Wannenwände, wo sie verklebt.

Während der beschriebene Prozeß schon bei geringen Druckunterschieden und Temperaturen abläuft (zum Beispiel 10 KPa; 80°C), erfolgt das Öffnen des Tintenloches 3 anschließend bei höheren Werten (zum Beispiel 1 bar; 120°C). Der verflüssigte Resist platzt am Tintenloch auf.

Der Vorschlag 1 arbeitet mit Positiv- oder Negativresistfolie (Erklärung: bei Positivresists können UV-belichtete Anteile, bei Negativresist die unbelichteten Anteile im Entwickler abgelöst werden). Bei Verwendung von Positivresist kann das Tintenloch auch durch Belichtung und Entwicklung der hier vorhandenen Resistfläche geöffnet werden.

Zu Vorschlag 2:

Verwendet man Positivresist als Kleber, so geschieht die Resistentfernung über der Wanne, in dem diese Bereiche der Schicht durch eine Maske belichtet und dann im Entwickler aufgelöst werden. Soll die Klebeschicht ganzflächig oder lokal dünner sein als die verfügbaren Resistfolien, so kann durch Anbelichten und Entwickeln ohne oder mit Maske ein Teil der Resistschicht abgetragen werden.

Bei Negativresist kann Resistfreiheit im Wannenbereich phototechnisch nicht erreicht werden, weil mit belichteten Schichtanteilen außerhalb des Wannenbereiches die Klebefähigkeit verloren ginge (Vorhärtung). Nach einer Weiterbildung der Erfindung wird deshalb die Wanne durch das Tintenloch mit Entwickler gefüllt und damit die überspannende Resistfolie abgelöst. In den übrigen Bereichen verhindert die Schutzfolie 5 den Entwicklerkontakt mit dem Resist. Damit die Füllung der Wanne mit Entwickler durch das enge Tintenloch (ca. 1 mm Durchmesser) überall in der Vielfachanordnung und vollkommen erfolgt, ist es zweckmäßig, das Eintauchen in den Entwickler innerhalb eines evakuierten Behälters vorzunehmen und dann zu belüften. Der äußere Überdruck drückt so die Entwicklerflüssigkeit in den (nahezu) luftleeren Wannenraum. Es ist auch möglich, die die Wanne überspannende Folie einzuschneiden oder zu lochen; dadurch wird der Entwickleraustausch verbessert. Beim selektiven Ablösen des Resists in der Wanne und beim anschließenden Spülen in Wasser ist Ultraschall von Vorteil. Neigt die Schutzfolie 5 dabei zum Ablösen von Resist, so kann das durch eine gitterförmige Andruckplatte in einem Halter verhindert werden; dabei können zum Beispiel Gumminippel im Wannenbereich auf die Schutzfolie drücken.

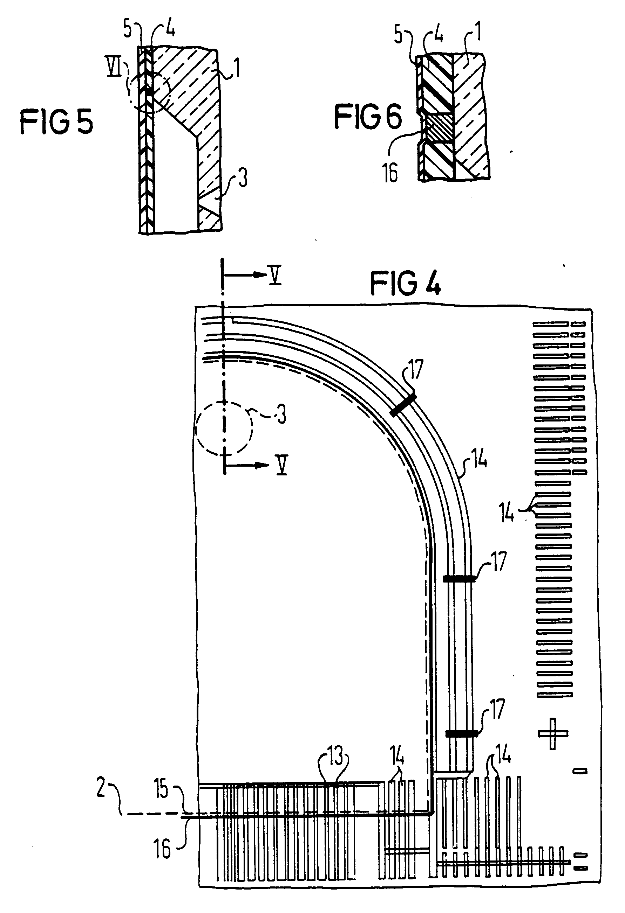

In den Figuren 4 bis 6 ist ein alternatives Verfahren zur Realisierung der Erfindung schematisch dargestellt. Die Figur 4 zeigt in der Aufsicht die Kanalplatte mit der das Substrat 1 verklebt wird. Die Kanalplatte trägt Oberflächenstrukturen, die auf einer Seite die Kanäle 13 und im übrigen Bereich geeignete Klebeflächen 14 bilden. Die Lage der Tintenwanne in der aufgeklebten Deckplatte ist mit einer gestrichelten Linie 15 angedeutet. Die ausgezogenen Linien 16 und 17 bedeuten belichtete, ausgehärtete Resistbereiche in der Klebeschicht auf der Deckplatte. Sie dienen einerseits als Abstandshalter 17 beim Kleben. Andererseits verhindert der um die Wanne laufende belichtete Steg 16 außer dem das im folgenden Absatz beschriebene Vordringen des Entwicklers über den Wannenbereich hinaus. Zahl und Form der Abstandshalter 17 können den jeweiligen Erfordernissen angepaßt werden.

Weil beim Auflösen des Resists in der Tintenwanne der Entwickler auch geringfügig Resistmaterial an der Kante zwischen Schutzfolie und Glasoberfläche herauslösen kann, ist es zweckmäßig, am Wannenrand vor der Entwicklung einen schmalen, umlaufenden Streifen 16 (zum Beispiel 70 µm breit) mit Hilfe einer Maske zu belichten, der den Entwickler stopt (Figur 4 bis 6). In Figur 5 ist zum besseren Verständnis der Photoresist 4 mit seiner Schutzfolie 5 vor dem Entfernen der Resistanteile im Wannenbereich dargestellt. Die Resistfolie in der Figur 6 über dem Karo 16 ist unbelichtet.

Ist der Wannenbereich resistfrei und gespült, so kann die Schutzfolie abgezogen werden.

Zu Vorschlag 1 und 2:

Beim Verkleben der Kanalplatte 1 und dem Deckglas in der Figur 4 müssen in der Regel zwei nicht völlig plane Oberflächen zusammengebracht werden. Es ist deshalb Druck auszuüben, der beim Aneinanderlegen, je nach Kleberviskosität, unzulässige lokale Kleberverschiebung, zum Beispiel in die Tintenkanäle, zur Folge hat. Daher ist es zweckmäßig und bei Negativresists möglich, nach dem Kaschieren der Resistfolie Bereiche in der Klebeschicht durch Belichten mit Maske vorzuhärten; damit sind Abstandhalter 17 erzeugt (Figur 4). Ihre Elastizität (Kompressibilität) kann, falls erwünscht, durch die Lichtdosis angepaßt werden. Generell erleiden belichtete Schichtanteile einen geringen Dickenschwund (ca. 2 bis 4 %), so daß die Kleberoberfläche in jedem Fall mit der Gegenfläche Kontakt bekommt (Figur 6). Nach dem Zusammenfügen der justierten Teile (Kanalplatte und Deckglas) unter Druck und Temperatur (Viskositätssteuerung) erfolgt die Aushärtung des Klebers durch Temperieren (ca. 200 °C). Bei Negativresist kann vorher eine ganzflächige UV-Belichtung durch das Glas erfolgen.

**Patentansprüche**

1. Verbindung von zwei flachen Teilen, zum Beispiel aus Glas, von denen das eine in der Verbindungsfläche Vertiefungen mit einem oder mehreren Durchbrüchen aufweist, zum Beispiel Tintenwannen (2) beim Bubble Jet Printer, **dadurch gekennzeichnet**, daß die beiden flachen Teile mit einer Zwischenlage aus einer Photoresistfolie (4), bevorzugt Resistfolien mit hoher Zeitstandfestigkeit wie die bekannten Lötstopresists, verklebt sind.

2. Verbindung nach Anspruch 1, **dadurch gekennzeichnet**, daß die Resistfolie (4) mit der sie abdeckenden Schutzfolie (5) ganzflächig auf dem mit Vertiefungen in Form von Tintenwannen (2) versehenen Teil kaschiert ist, wobei die Tintenwannen (2) von der Resistfolie überspannt werden.

3. Verbindung nach Anspruch 2, **dadurch gekennzeichnet**, daß die Folie (4) im Bereich der Tintenwannen (2) nach Entfernen der Schutzfolie (5) tiefgezogen ist, so daß die Wannenwände ausgekleidet sind, und daß anschließend das Durchgangsloch (3) geöffnet wird.

4. Verbindung nach Anspruch 2, **dadurch gekennzeichnet**, daß die Resistfolie (4) im Bereich der Tintenwanne (2) entfernt und nur noch an der zu klebenden Oberfläche vorhanden ist.

5. Verfahren zur Herstellung der Verbindung nach Anspruch 3, **dadurch gekennzeichnet**, daß die Photoresistfolie (4) vor dem Tiefziehen im Wannenbereich (2) durch eine Maske mit sehr geringer Dosis anbelichtet und anschließend die Schutzfolie (5) entfernt wird.

6. Verfahren zur Herstellung der Verbindung nach Anspruch 3, **dadurch gekennzeichnet**, daß das Tiefziehen über einen Tiefziehprozeß mit Druckunterschieden (zum beispiel 10 kPa) beiderseits der Resistfolie bei erhöhter Temperatur (zum Beispiel 80°C) erfolgt (Figur 3).

7. Verfahren zur Herstellung der Verbindung nach den Ansprüchen 3 und 6, **dadurch gekennzeichnet**, daß zur Vermeidung von Lufteinschlüssen der Druckunterschied beiderseits der Resistfolie (4) durch Evakuieren der Luft in der Tintenwanne (2) erzeugt wird.

8. Vorrichtung zur Durchführung des Verfahrens nach den Ansprüchen 6 und 7, **dadurch gekennzeichnet**, daß der Tiefziehvorgang in einer aus Ober- (6) und Unterteil (7) bestehenden Kammer vor sich geht, wobei durch eine Vakuumleitung (9) und Ventile (10 - 12) der Druckunterschied definiert eingestellt wird.

9. Verfahren nach den Ansprüchen 5 bis 8, **dadurch gekennzeichnet**, daß man das Durchgangsloch (3) durch Anwendung höherer Druckunterschiede (zum beispiel 100 kPa) und Temperatur (zum Beispiel 120°C) öffnet.

10. Verfahren nach den Ansprüchen 5 bis 8, **dadurch gekennzeichnet**, daß bei der Verwendung von Positivresist der Resist (4) im Bereich des Durchgangsloches (3) belichtet und wegentwickelt wird.

11. Verfahren zur Herstellung der Verbindung nach Anspruch 4 bei der Verwendung von Positivresist, **dadurch gekennzeichnet**, daß die Bereiche des Photoresists (4) über der Wanne (2) durch eine Maske belichtet und dann in einem Entwickler aufgelöst werden.

12. Verfahren zur Herstellung der Verbindung nach den Ansprüchen 1 bis 4 und bei Verwendung von Positivresist zur teilweisen oder ganzflächigen Ausdünnung der verfügbaren Resistfolie (4), **dadurch gekennzeichnet**, daß durch Anbelichten und Entwickeln mit oder ohne Maske ein Teil der Resistschicht (4) abgetragen wird.

13. Verfahren zur Herstellung der Verbindung nach den Ansprüchen 2 und 4 bei der Verwendung von Negativresist, **dadurch gekennzeichnet**, daß die die Tintenwanne (2) überspannende Resistfolie (4) durch ihren Entwickler abgelöst wird, in dem man das Teil in einer Kammer mit Unterdruck in den Entwickler eintaucht, so daß die Tintenwannen (2) weitgehend von Luft evakuiert werden und bei Belüftung der Kammer Entwickler in die Tintenwannen (2) gedrückt wird.

14. Verfahren nach Anspruch 13, **dadurch gekennzeichnet**, daß zur Verbesserung des Entwickleraustausches in der Tintenwanne (2) die Schutzfolie (5) über der Wanne (2) lokal eingeschnitten wird.

15. Verfahren nach Anspruch 13, **dadurch gekennzeichnet**, daß das Ablösen des Resists (4) in der Tintenwanne (2) durch Anwendung von Ultraschall erleichtert wird.

16. Verfahren nach Anspruch 15, **dadurch gekennzeichnet**, daß mit Hilfe einer angedrückten Gitterplatte ein Ablösen der Schutzfolie (5) verhindert wird.

17. Verfahren nach den Ansprüchen 13 bis 16, **dadurch gekennzeichnet**, daß vor dem Ablösen des Resists (4) im Wannenbereich (2) ein um die Tintenwanne (2) laufender Streifen (16) mit Hilfe einer Maske belichtet wird, der den Entwickler stopt.

18. Verfahren nach einem der vorhergehenden Ansprüche, **dadurch gekennzeichnet**, daß bei der Verwendung von Negativresist Bereiche der Klebeschicht zur Erzeugung von Abstandshaltern (17) für den Klebevorgang belichtet und damit vorgehärtet werden.

19. Verfahren nach einem der vorhergehenden Ansprüche, **dadurch gekennzeichnet**, daß nach dem Zusammenfügen der zu verklebenden Teile die Kleberschicht sowohl durch UV-belichtung und erhöhte Temperatur oder nur durch Temperieren gehärtet wird.

## Claims

1. Connection of two flat parts, for example made of glass, of which one has depressions in the connecting face with one or more openings, for example ink wells (2) in the bubble jet printer, characterised in that the two flat parts are bonded to an intermediate layer made of a photoresist film (4), preferably resist films with a high long-time rupture strength such as the known solder stop resists.

2. Connection according to Claim 1, characterised in that the resist film (4) with the protective film (5) covering it is laminated over the entire surface on the part provided with depressions in the form of ink wells (2), the ink wells (2) being covered by the resist film.

3. Connection according to Claim 2, characterised in that the film (4) is deep-drawn in the region of the ink wells (2) after the removal of the protective film (5) so that the well walls are lined and the passage hole (3) is subsequently opened.

4. Connection according to Claim 2, characterised in that the resist film (4) is removed in the region of the ink well (2) and is only still present on the surface to be bonded.

5. Method for manufacturing the connection according to Claim 3, characterised in that the photoresist film (4) is exposed before the deep-drawing in the well region (2) by means of a mask with a very low dose, and the protective film (5) is subsequently removed.

6. Method for manufacturing the connection according to Claim 3, characterised in that the deep-drawing occurs by means of a deep-drawing process with pressure differences (for example 10 kPa) on both sides of the resist film at a raised temperature (for example 80°C) (Figure 3).

7. Method for manufacturing the connection according to Claims 3 and 6, characterised in that in order to avoid air occlusions, the pressure difference on both sides of the resist film (4) is produced by evacuating the air in the ink well (2).

8. Device for carrying out the method according to Claims 6 and 7, characterised in that the deep-drawing process proceeds in a chamber consisting of an upper part (6) and a lower part (7), the pressure difference being set in a defined manner by means of a vacuum line (9) and valves (10 - 12).

9. Method according to Claims 5 to 8, characterised in that the passage hole (3) is opened by the use of relatively high pressure differences (for example 100 kPa) and temperature (for example 120°C).

10. Method according to Claims 5 to 8, characterised in that when using positive resist the resist (4) is exposed in the region of the passage hole (3) and developed away.

11. Method for manufacturing the connection according to Claim 4 when using positive resist, characterised in that the regions of the photoresist (4) over the well (2) are exposed by a mask and then dissolved in a developer.

12. Method for manufacturing the connection according to Claims 1 to 4 and when using positive resist for thinning out the available resist layer (4) over part or all of the surface, characterised in that by exposing and developing with or without mask a portion of the resist film (4) is taken off.

13. Method for manufacturing the connection according to Claims 2 and 4 when using negative resist, characterised in that the resist film (4) covering the ink well (2) is detached by its developer by dipping the part into the developer in a chamber at underpressure so that the air in the ink wells (2) is largely evacuated and when the chamber is ventilated developer is forced into the ink wells (2).

14. Method according to Claim 13, characterised in that in order to improve the developer exchange in the ink well (2) the protective film (5) is locally indented over the well (2).

15. Method according to Claim 13, characterised in that the detachment of the resist (4) in the ink well (2) is made easier by the use of ultrasonic sound.

16. Method according to Claim 15, characterised in that detachment of the protective foil (5) is prevented with the aid of a pressed-on grid plate.

17. Method according to Claims 13 to 16, characterised in that before the detachment of the resist (4) in the well region (2), a strip (16) running around the ink well (2) is exposed with the aid of a mask, which stops the developer.

18. Method according to one of the preceding claims, characterised in that when using negative resist, regions of the bonding layer are exposed in order to produce spacing elements (17) for the bonding process and are thus precured.

19. Method according to one of the preceding claims, characterised in that after the parts to be bonded are joined together, the bonding layer is cured both by exposure to ultraviolet light and raised temperature or only by tempering.

**Revendications**

1. Liaison de deux parties plates, par exemple en verre, dont l'une comporte, dans la surface de liaison, des cavités avec un ou plusieurs passages, par exemple de cuvettes à encre (2) d'un Bubble Jet Printer, caractérisée en ce que les deux surfaces plates sont collées par une couche intermédiaire en une feuille de photorésist (4), de préférence des feuilles de photorésist ayant une grande résistance à la rupture, comme les résists connus d'arrêt de brasure.

2. Liaison suivant la revendication 1, caractérisée en ce que la feuille de résist (4) avec la feuille de protection (5) qui la recouvre, est plaquée sur toute la surface sur la partie munie de cavités en forme de cuvettes à encre (2), les cuvettes à encre (2) étant recouvertes de la feuille de résist.

3. Liaison suivant la revendication 2, caractérisée en ce que la feuille (4) est emboutie profondément dans la région des cuvettes à encre (2) après enlèvement de la feuille de protection (5), de manière à revêtir les parois des cuvettes et, ensuite, le trou de passage (3) est ouvert.

4. Liaison suivant la revendication 2, caractérisée en ce que la feuille de résist (4) est enlevée dans la région de la cuvette à encre (2) et n'est plus présente que sur la surface à coller.

5. Procédé de fabrication de la liaison suivant la revendication 3, caractérisé en ce que la feuille de photorésiste (4) est exposée avant emboutissage profond dans la région de la cuvette (2), à travers un masque, à une dose très faible, et ensuite, la feuille de protection (5) est enlevée.

6. Procédé de fabrication de la liaison suivant la revendication 3, caractérisé en ce que l'emboutissage profond s'effectue par un processus d'emboutissage profond avec différence de pression (par exemple 10 kPa) de part et d'autre de la feuille de résist, et à une tempérture élevée (par exemple 80°C) (figure 3).

7. Procédé de fabrication de la liaison suivant la revendication 3 ou 6, caractérisé en ce que, pour empêcher des inclusions d'air, la différence de pression de part et d'autre de la feuille de résiste (4) est produite par évacuation de l'air de la cuvette à encre (2).

8. Dispositif pour la mise en oeuvre du procédé suivant la revendication 6 ou 7, caractérisé en ce que le processus d'emboutissage profond s'effectue dans une chambre constituée d'une partie supérieure (6) et d'une partie inférieure (7), la différence de pression étant réglée à une valeur définie par un conduit de mise sous vide (9) et par des soupapes (10 à 12).

9. Procédé suivant l'une des revendications 5 à 8, caractérisé en ce que l'on ouvre le trou de passage (3) en utilisant une différence de pression plus grande (par exemple 100 kPa) et une température plus élevée (par exemple 120°C).

10. Procédé suivant l'une des revendications 5 à 8, caractérisé en ce que, lorsque l'on utilise un résiste positif, on expose le résist (4) dans la région du trou de passage (3) et on l'élimine par développement.

11. Procédé de fabrication de la liaison suivant la revendication 4, lorsqu'on utilise un résist positif, caractérisé en ce que les régions du photorésist (4) au-dessus de la cuvette (2) sont exposées à travers un masque et sont ensuite dissoutes dans un révélateur.

12. Procédé de fabrication de la liaison suivant l'une des revendications 1 à 4 et lors de l'utilisation de résists positifs pour amincir partiellement ou sur toute la surface la feuille de résist (4) disponible, caractérisé en ce que l'on enlève une partie de la couche de résist (4) par exposition et développement avec ou sans masque.

13. Procédé de fabrication de la liaison suivant l'une des revendications 2 ou 4, lorsque l'on utilise un résist négatif, caractérisé en ce que la feuille de résist (4) recouvrant la cuvette à encre (2) est détachée par son révélateur, en immergeant la partie dans le révélateur dans une chambre en dépression de manière à évacuer dans une grande mesure l'air des cuvettes à encre (2) et de manière à refouler, lors de l'arrivée de l'air dans la chambre, le révélateur dans les cuvettes à encre (2).

14. Procédé suivant la revendication 13, caractérisé en ce que pour faciliter le remplacement du révélateur de la cuvette à encre (2), la feuille de protection (5) est découpée localement au-dessus de la cuvette (2).

15. Procédé suivant la revendication 13, caractérisé en ce que le détachement du résist (4) dans la cuvette à encre (2) est facilité par l'utilisation d'ultrasons.

16. Procédé suivant la revendication 15, caractérisé en ce que tout détachement de la feuille de protection (5) est empêché à l'aide d'un treillis qui y est appliqué.

17. Procédé suivant l'une des revendications 13 à 16, caractérisé en ce qu'avant la détachement du résist (4) dans la région de la cuvette (2), une bande (16) s'étendant autour de la cuvette à encre (2) est exposée à l'aide d'un masque qui arrête le révélateur.

18. Procédé suivant l'une des revendications précédentes, caractérisé en ce que, lorsque l'on utilise un résist négatif, des régions de la couche de colle sont exposées et donc, prédurcies pour produire des entretoises (17) pour le processus de collage.

19. Procédé suivant l'une des revendications précédentes, caractérisé en ce qu'après l'assemblage des parties à coller, la couche de colle est durcie à la fois par exposition à des rayonnements ultraviolets et à température élevée, ou seulement par mise en température.

FIG 1

FIG 2

FIG 3

FIG 5

FIG 6

FIG 4